(19)

Europäisches
Patentamt
European
Patent Office
Office européen
des brevets

(11) **EP 2 565 660 A1**

(12) **EUROPEAN PATENT APPLICATION**
published in accordance with Art. 153(4) EPC

(43) Date of publication:
06.03.2013 Bulletin 2013/10

(51) Int Cl.:
*G01R 31/36* (2006.01)

(21) Application number: 10850633.8

(86) International application number:
PCT/JP2010/002995

(22) Date of filing: 26.04.2010

(87) International publication number:
WO 2011/135609 (03.11.2011 Gazette 2011/44)

(84) Designated Contracting States:
AT BE BG CH CY CZ DE DK EE ES FI FR GB GR
HR HU IE IS IT LI LT LU LV MC MK MT NL NO PL
PT RO SE SI SK SM TR

(71) Applicant: TOYOTA JIDOSHA KABUSHIKI
KAISHA
Toyota-shi,
Aichi-ken, 471-8571 (JP)

(72) Inventor: TAKAGI, Masaru
Aichi 471-8571 (JP)

(74) Representative: TBK
Bavariaring 4-6
80336 München (DE)

(54) **DEGRADATION ESTIMATION DEVICE AND DEGRADATION ESTIMATION METHOD FOR STORAGE BATTERY DEVICE**

(57)    A deterioration estimating apparatus estimates a deterioration state of an electric storage element when the electric storage element is used, a deterioration value indicating the deterioration state being in a proportional relationship with an nth root of an elapsed time (where n is a value larger than one), and the proportional relationship being changed in accordance with a deterioration condition. The apparatus includes a computing device accumulating change amounts of the deterioration value in a plurality of the deterioration conditions and calculating a deterioration value of the electric storage element when a predetermined time period elapses. The computing device predicts a period for which each of the deterioration conditions occurs before the elapse of the predetermined time period. The computing device calculates a change amount of the deterioration value in each of the deterioration conditions based on a deterioration characteristic indicating a relationship between the deterioration value and the elapsed time and the period of occurrence of each of the deterioration conditions, and adds the calculated change amounts sequentially by using the deterioration value provided before each addition as a reference to calculate each change amount of the deterioration value to be added.

FIG. 6

EP 2 565 660 A1

**Description**

[TECHNICAL FIELD]

The present invention relates to an apparatus and a method for estimating the deterioration state of an electric storage element.

[BACKGROUND ART]

Patent Document 1 has described calculation of the deterioration amount of a storage battery separately when the temperature of the storage battery is equal to or lower than 25°C and when the temperature of the storage battery is higher than 25°C. Specifically, the deterioration capacity is calculated by multiplying the deterioration capacity in each of the two temperature regions by a time period for which the measured temperature falls within each of those temperature regions. Then, the two calculated deterioration capacities are added to calculate the deterioration capacity found from the start of the use of the storage battery to the elapse of a predetermined time period.

[PRIOR ART DOCUMENT]

[PATENT DOCUMENT]

    Patent Document 1: Japanese Patent Laid-Open No. 2003-161768
    Patent Document 2: Japanese Patent Laid-Open No. 2007-057433
    Patent Document 3: Japanese Patent Laid-Open No. 2000-228227

[SUMMARY OF THE INVENTION]

[PROBLEMS TO BE SOLVED BY THE INVENTION]

In Patent Document 1, the deterioration capacity is determined in each of two temperature regions and these deterioration capacities are merely added. The simple addition of the plurality of deterioration amounts may be insufficient in estimating the deterioration state of the battery.

[MEANS FOR SOLVING THE PROBLEMS]

According to a first aspect, the present invention provides a deterioration estimating apparatus estimating a deterioration state of an electric storage element when the electric storage element is used, a deterioration value indicating the deterioration state being in a proportional relationship with an nth root of an elapsed time (where n is a value larger than one), and the proportional relationship being changed in accordance with a deterioration condition. The deterioration estimating apparatus includes a computing device accumulating change amounts of the deterioration value in a plurality of the deterioration conditions and calculating a deterioration value of the electric storage element when a predetermined time period elapses. The computing device predicts a period for which each of the deterioration conditions occurs before the elapse of the predetermined time period. The computing device calculates a change amount of the deterioration value in each of the deterioration conditions based on a deterioration characteristic indicating a relationship between the deterioration value and the elapsed time and the period of occurrence of each of the deterioration conditions, and adds the calculated change amounts sequentially by using the deterioration value provided before each addition as a reference to calculate each change amount of the deterioration value to be added.
The total sum of the change amounts of the deterioration value can be calculated on the basis of the following expression (Ex1):
$$\Delta d_{total} \;=\; \sqrt[n]{\sum \left( v(f)^{n} * t(f) \right)} \qquad (\text{Ex1})$$

where Δd_total represents the total sum of the change amounts of the deterioration value, v(f) represents a deterioration speed provided for each of the deterioration conditions and indicating a change in the deterioration value with respect to the elapsed time, and t(f) represents the predicted period of occurrence of each of the deterioration conditions.

The deterioration characteristic in each of the deterioration conditions can be stored in a memory. Thus, the deterioration characteristic can be read from the memory to calculate the change amount of the deterioration value in each of the deterioration conditions.

A detection sensor for detecting the deterioration condition, and a timer measuring a time can also be included. The computing device can use the detection sensor and the timer to acquire a period of occurrence of each of the deterioration conditions before the elapse of a time period shorter than the predetermined time period, and based on the acquired period of occurrence, predict the period of occurrence of each of the deterioration conditions before the elapse of the predetermined time period. Thus, the period of occurrence of the deterioration condition can be predicted on the basis of the measured value to improve the accuracy in calculating the change amount of the deterioration rate.

An acquiring sensor for acquiring the deterioration value, and a timer measuring a time can also be included. The computing device can determine whether or not the deterioration value acquired with the acquiring sensor is proportional to an nth root of an elapsed time acquired with the timer, and when the deterioration value is proportional to the nth root of the elapsed time, the computing device can calculate the deterioration value of the electric storage element when the predetermined time period elapses. Thus, it can be determined whether or not the electric storage element is applicable to the estimation of the deterioration state in the present invention.

The deterioration value can be provided by using a ratio between an internal resistance of the electric storage element in an initial state and an internal resistance of the electric storage element in a deteriorated state. The internal resistance of the electric storage element can be used as the deterioration value. The deterioration condition can include a temperature in the electric storage element, a value indicating a charge state (SOC), and a current value. The n described above can be set to two.

According to a second aspect, the present invention provides a deterioration estimating method estimating a deterioration state of an electric storage element when the electric storage element is used, a deterioration value indicating the deterioration state being in a proportional relationship with an nth root of an elapsed time (where n is a value larger than one), and the proportional relationship being changed in accordance with a deterioration condition. The method includes a first step of predicting a period for which each of the deterioration conditions occurs before the elapse of a predetermined time period, and a second step of calculating a change amount of the deterioration value in each of the deterioration conditions based on a deterioration characteristic indicating a relationship between the deterioration value and the elapsed time and the period of occurrence of each of the deterioration conditions, and adding the calculated change amounts sequentially to calculate a deterioration value of the electric storage element when the predetermined time period elapses. At the second step, each change amount of the deterioration value to be added is calculated by using the deterioration value provided before each addition as a reference.

[ADVANTAGE OF THE INVENTION]

According to the present invention, the change amounts of the deterioration value can be accumulated in accordance with the deterioration characteristics of the electric storage element to improve the accuracy in estimating the deterioration state.

[BRIEF DESCRIPTION OF THE DRAWINGS]

[Fig. 1] A block diagram showing the configuration of a deterioration estimating apparatus which is Embodiment 1 of the present invention.
[Fig. 2] A block diagram showing the configuration of part of a vehicle on which the deterioration estimating apparatus is mounted in Embodiment 1.
[Fig. 3] A flow chart showing processing of acquiring frequency of occurrence of each of a plurality of temperature states.
[Fig. 4] A graph showing the frequency of occurrence of each of the plurality of temperature states.
[Fig. 5] A flow chart showing processing of estimating a deterioration state of an assembled battery.
[Fig. 6] A graph showing a relationship between a deterioration rate and an elapsed time.
[Fig. 7] A graph showing a relationship between the deterioration rate and the square root of the elapsed time.
[Fig. 8] An explanatory diagram for comparing methods of estimating the deterioration state.

[MODE FOR CARRYING OUT THE INVENTION]

An embodiment of the present invention will hereinafter be described.

Embodiment 1

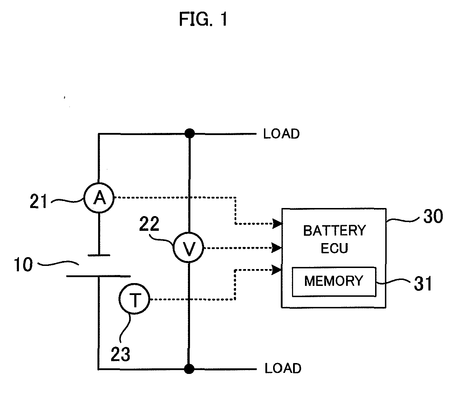

A deterioration estimating apparatus which is Embodiment 1 of the present invention is provided for estimating the deterioration state of a cell (electric storage element). The configuration thereof is described with reference to Fig. 1.

A cell 10 is a secondary battery such as a nickel metal hydride battery and a lithium-ion battery, and is connected to a load. An electric double layer capacitor may be used instead of the secondary battery. A current sensor 21 detects the value of an electric current (charge current or discharge current) passing through the cell 10 and outputs the detection result to a battery ECU (Electric Control Unit, corresponding to a computing device) 30. A voltage sensor 22 detects the value of a voltage of the cell 10 and outputs the detection result to the battery ECU 30.

A temperature sensor 23 detects the temperature of the cell 10 and outputs the detection result to the battery ECU 30. The temperature sensor 23 is only required to detect the temperature of the cell 10 directly or indirectly. When the temperature sensor 23 is brought into contact with an outer face of the cell 10, the temperature of the cell 10 can be detected directly. Alternatively, when the temperature sensor 23 is placed at a position near the cell 10 and not in contact with the cell 10, the temperature of the cell 10 can be detected indirectly. The battery ECU 30 includes a memory 31 and a timer 32. Alternatively, the memory 31 and the timer 32 may be provided outside the battery ECU 30.

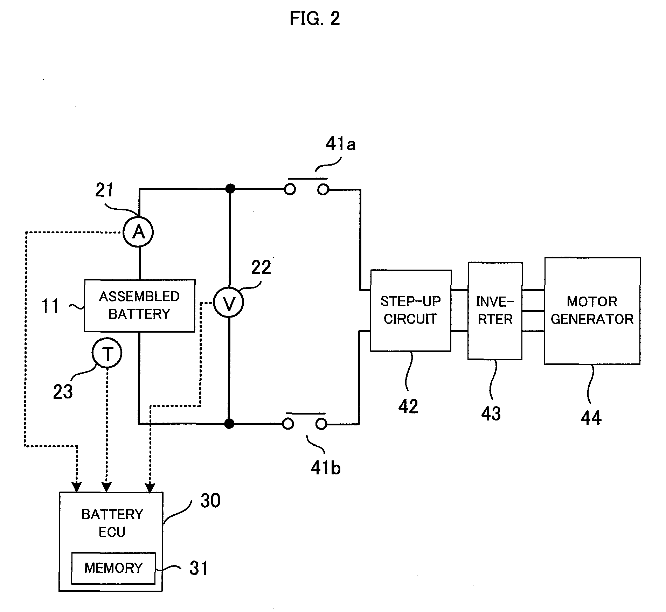

The deterioration estimating apparatus which is the present embodiment can be mounted on a vehicle. The configuration when the deterioration estimating apparatus is mounted on the vehicle is described with reference to Fig. 2. A hybrid vehicle and an electric vehicle can be used as the vehicle. In Fig. 2, the same components as those described in Fig. 1 are designated with the same reference numerals.

For mounting the cell 10 on the vehicle, an assembled battery 11 is used. The assembled battery 11 can be formed by connecting a plurality of cells 10 electrically in series. The assembled battery 11 may include cells 10 connected electrically in parallel. The number of the cells 10 constituting the assembled battery 11 may be set as appropriate based on the required output of the assembled battery 11.

The assembled battery 11 is connected to a step-up circuit (DC/DC converter) 42 through systemmain relays 41a and 41b. Switching between ON and OFF of each of the system main relays 41a and 41b is controlled by the battery ECU 30. The step-up circuit 42 increases the output voltage of the assembled battery 11 and supplies the increased voltage to an inverter 43. The inverter 43 converts the DC power supplied from the step-up circuit 42 into an AC power and the supplies the AC power to a motor generator (for example, a three-phase AC motor) 44. The motor generator 44 is connected to wheels (not shown) and receives the AC power from the inverter 43 to generate a kinetic energy for running of the vehicle.

In braking of the vehicle, the motor generator 44 converts a kinetic energy into an electric energy and supplies the electric energy to the inverter 43. The inverter 43 converts the AC power from the motor generator 44 into a DC power and supplies the DC power to the step-up circuit 42. The step-up circuit 42 reduces the voltage from the inverter 43 and supplies the reduced voltage to the assembled battery 11. The assembled battery 11 can store the electric power from the step-up circuit 42.

Next, processing of estimating the deterioration state of the assembled battery 11 is described. In the present embodiment, the deterioration state of the assembled battery 11 is estimated on the basis of the temperature of the assembled battery 11. The deterioration state refers to a ratio between the internal resistance of the assembled battery 11 which is in an initial state and the internal resistance of the assembled battery 11 which is in a deteriorated state, and can be represented by the following expression (1).

$$D \ = \ \frac{R_2}{R_1} \qquad (1)$$

where D represents the deterioration rate which is a deterioration value indicating the deteriorated state, R1 represents the internal resistance of the assembled battery 11 in the initial state, and R2 represents the internal resistance of the assembled battery 11 in the deteriorated state. As the assembled battery 11 is more deteriorated, the internal resistance R2 is increased.

While the ratio between the internal resistances R1 and R2 is used as the deterioration state in the present embodiment, the present invention is not limited thereto, and any parameter can be used as long as the deterioration state can be determined.

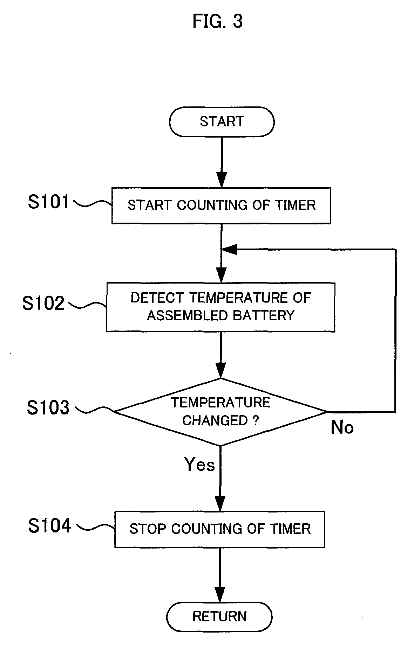

First, data for use in the estimation of the deterioration state is acquired as shown in a flow chart of Fig. 3. The flow chart shown in Fig. 3 is performed by the battery ECU 30.

At step S101, the battery ECU 30 starts counting of the timer 32. The timer 32 is used to measure a time period for which the assembled battery 11 is maintained at an arbitrary temperature. At step S102, the battery ECU 30 detects the temperature of the assembled battery 11 at this point in time based on the output from the temperature sensor 23. The processing operations at step S101 and step S102 can be performed in reverse order or simultaneously.

At step S103, the battery ECU 30 determines whether or not the detected temperature acquired at step S102 is changed. Specifically, it is determined whether or not the detected temperature falls within any one of a plurality of separate temperature ranges. In the present embodiment, it is determined that the detected temperature is changed when a change on the left of the decimal point is detected, or it is determined that the detected temperature is not changed when a change on the right of the decimal point is detected.

For example, when the temperature of the assembled battery 11 is changed from 16°C to 17°C, it is determined that the detected temperature is changed at the processing of step S103. On the other hand, when the temperature of the assembled battery 11 is changed from 16.2°C to 16.8°C, it is determined that the detected temperature is not changed at the processing of step S103. If a numeric value on the right of the decimal point can not be detected, it can be determined that the detected temperature is changed in response to any change in the numeric value.

When it is determined that the detected temperature is changed at step S103, the process proceeds to step S104. When it is determined that the detected temperature is not changed, the process returns to step S102 to continue the detection of the temperature of the assembled battery 11. While a change in numeric value on the left of the decimal point is defined as a change in the detected temperature in the present embodiment, the present invention is not limited thereto. The condition for determining whether or not the detected temperature is changed can be set as appropriate.

At step S104, the battery ECU 30 stops the counting of the timer 32 and stores the count time of the timer 32 in the memory 31. The count time serves as a time period for which the assembled battery 11 is maintained in a particular temperature state.

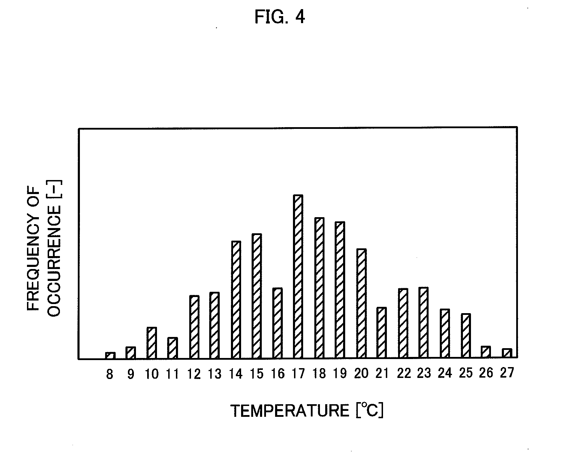

When the processing shown in Fig. 3 is performed for a predetermined time period, data shown in Fig. 4 (by way of example) is provided. In Fig. 4, the horizontal axis represents the temperature of the assembled battery 11, and the vertical axis represents the frequency of occurrence of each temperature. The frequency of occurrence refers to a frequency with which a particular temperature occurs, and can be represented by the following expression (2).

$$F(T_k) = \frac{t1(T_k)}{t1_{total}} \qquad (2)$$

where F(Tk) represents the frequency of occurrence of a temperature Tk, t1_total represents the period for which the processing shown in Fig. 3 is performed, and represents the total sum of the periods of all the detected temperatures, and t1 (Tk) represents a cumulative time period for which the assembled battery 11 is at a temperature Tk. The cumulative time t1(Tk) is the time period for which the temperature Tk occurs if the state of the temperature Tk occurs only once, or is the total time period of the occurrences if the state of the temperature Tk occurs more than once. The time period for collecting the data shown in Fig. 4 can be set as appropriate, and can be set to one year, for example.

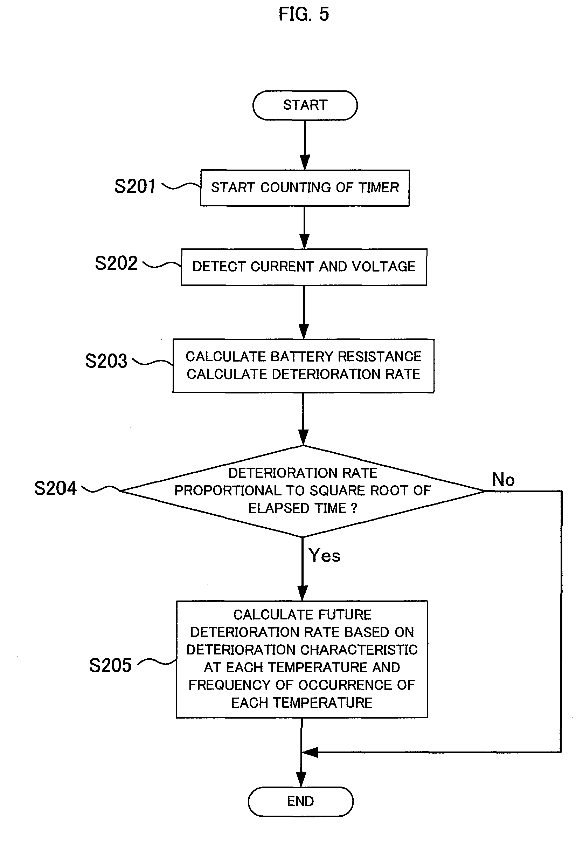

Next, the processing of estimating the deterioration state of the assembled battery 11 is described with reference to Fig. 5. The processing shown in Fig. 5 is performed by the battery ECU 30.

At step S201, the battery ECU 30 starts counting of the timer 32. At step S202, the battery ECU 30 detects the current value of the assembled battery 11 based on the output from the current sensor 21 and detects the voltage value of the assembled battery 11 based on the output from the voltage sensor 22.

At step S203, the battery ECU 30 calculates the resistance of the assembled battery 11 at this point in time based on the current value and the voltage value detected at step S202 and calculates a deterioration rate of the assembled battery 11. The deterioration rate is calculated on the basis of the above expression (1). The calculation of the deterioration rate is repeatedly performed to provide data which indicates a correspondence between the elapsed time and the deterioration rate.

At step S204, the battery ECU 30 determines whether or not the deterioration rate is proportional to the square root of the elapsed time by using the data indicating the correspondence between the elapsed time and the deterioration rate. In other words, it is determined whether or not the processing of estimating the deterioration state in the present embodiment can be applied. When the deterioration rate is proportional to the square root of the elapsed time at step S204, the process proceeds to step S205, and when not, the processing is ended.

At step S205, the battery ECU 30 uses the deterioration characteristics of the assembled battery 11 at each temperature and the frequency of occurrence of each temperature to calculate the future deterioration rate when a predetermined time period elapses. The specific processing at step S205 is described later.

While it is determined whether or not the processing of estimating the deterioration state in the present embodiment can be applied to the assembled battery 11 by determining whether or not the deterioration rate is proportional to the square root of the elapsed time in the processing shown in Fig. 5, this determination can be omitted. Specifically, the determination can be omitted when it is previously known that the deterioration rate is proportional to the square root of the elapsed time. For example, since the lithium-ion secondary battery highly tends to have the deterioration rate proportional to the square root of the elapsed time, the determination processing described in Fig. 5 can be omitted when the lithium-ion secondary battery is used as the cell 10.

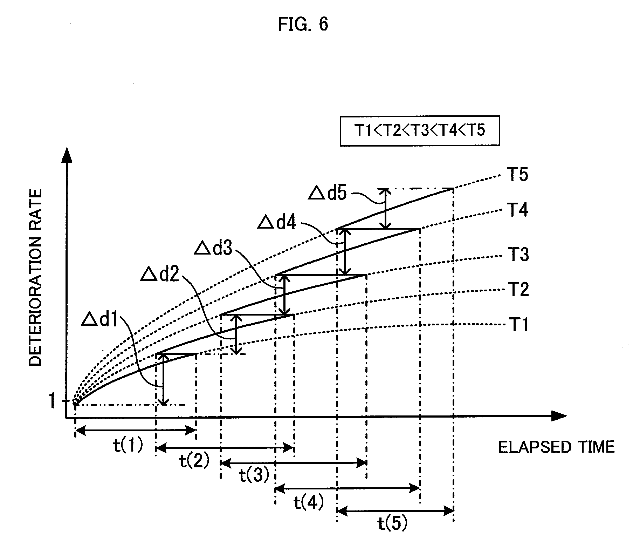

Next, the processing at step S205 in Fig. 5 is described specifically with reference to Fig. 6. This processing is performed to predict the deterioration rate of the assembled battery 11 when a period t2_total has elapsed since the start of the use of the assembled battery 11. The period t2_total is longer than the abovementioned period t1_total.

The memory 31 has five deterioration curves (data) indicated by dotted lines in Fig. 6 stored therein. Each of the deterioration curves (corresponding to the deterioration characteristics) shows a change in deterioration rate at each of temperatures T1 to T5. The vertical axis in Fig. 6 represents the deterioration rate of the assembled battery 11, and the horizontal axis represents the elapsed time. Each of the deterioration curves shown in Fig. 6 can be previously determined with experiments or the like. The temperature is increased in the order of T1, T2, T3, T4, and T5. As the temperature is higher, the deterioration rate is higher.

First, the period occupied by the state of each of the temperatures T1 to T5 in the period t2_total is determined. It is assumed that the state of each of the temperatures T1 to T5 occurs during the period t2_total. The period t2_total is divided in accordance with the frequency of occurrence of each of the temperatures T1 to T5 shown in Fig. 4. Specifically, the period occupied by the state of each of the temperatures T1 to T5 is determined on the basis of the following expression (3). The total sum of the periods occupied by the states of the temperature T1 to T5 is equal to the period t2_total.

$$t2(T_k) = t2_{total} * F(T_k) \qquad (3)$$

where t2(Tk) represents the period occupied by the state of the temperature Tk in the period t2_total, and F(Tk) represents the frequency of occurrence of the temperature Tk. The frequency of occurrence F(Tk) can be acquired from the data shown in Fig. 4 as described above.

In the above expression (2), t1(Tk) represents the measured time for which the state of the temperature Tk occurs. In the above expression (3), t2 (Tk) represents the predicted time for which the state of the temperature Tk occurs. While the period t2(Tk) is calculated on the basis of the frequency of occurrence F(Tk) in the present embodiment, the present invention is not limited thereto. For example, the period t2 (Tk) can be set as appropriate without using the frequency of occurrence F(Tk).

Once the period t2(Tk) is acquired, a change amount of deterioration rate at the temperature Tk can be calculated by using the deterioration curve shown in Fig. 6. The change amounts of deterioration rate at a plurality of temperatures Tk are accumulated and the resulting value is set as the deterioration rate of the assembled battery 11 when the time t2_total elapses.

In the example shown in Fig. 6, periods t2(T1) to t2(T5) at the temperatures T1 to T5 are set as t (1) to t (5), respectively. Then, the change amount of deterioration rate at each of the temperatures T1 to T5 is calculated, and the calculated change amounts of deterioration rate can be accumulated to determine the deterioration rate of the assembled battery 11 when the time t2_total elapses. The period t2_total corresponds to the total sum of the periods t(1) to t(5).

Description is now made of a (exemplary) method of accumulating the change amounts of deterioration rate. When the state of the temperature T1 occurs only in the period t(1) in Fig. 6, the deterioration rate is increased by Δd1. Specifically, the deterioration rate is increased by the change amount Δd1 relative to the deterioration rate when the assembled battery 11 is in the initial state. When the assembled battery 11 is in the initial state, the deterioration rate (see the above expression (1)) is a value generally equal to one.

Next, the change amount of deterioration rate at the temperature T2 is calculated. The calculation of the change amount of the deterioration rate at the temperature T2 is performed by using the deterioration rate after the increase by Δd1 as the reference. Specifically, the change amount of deterioration rate is calculated from the point corresponding to the deterioration rate after the increase by Δd1 to the point when the period t(2) elapses in the deterioration curve for the temperature T2. In other words, the deterioration rate is increased by Δd2 when the state of the temperature T2 occurs for the period t(2).

The calculation of the change amount of deterioration rate at the temperature T3 is performed by using the deterioration rate after the increase by Δd1+Δd2 as the reference. The calculation is performed similarly to the calculation of the change amount Δd2 of deterioration rate at the temperature T2. The deterioration rate is increased by Δd3 when the state of the temperature T3 occurs for the period t(3).

The calculation of the change amount of deterioration rate at the temperature T4 is performed by using the deterioration rate after the increase by Δd1+Δd2+Δd3 as the reference. The calculation is performed similarly to the calculation of the change amount Δd2 of deterioration rate at the temperature T2. The deterioration rate is increased by Δd4 when the state of the temperature T4 occurs for the period t(4).

The calculation of the change amount of deterioration rate at the temperature T5 is performed by using the deterioration rate after the increase by Δd1+Δd2+Δd3+Δd4 as the reference. The calculation is performed similarly to the calculation of the change amount Δd2 of deterioration rate at the temperature T2. The deterioration rate is increased by Δd5 when the state of the temperature T5 occurs for the period t(5).

Thus, the deterioration rate of the assembled battery 11 when the time t2_total elapses can be estimated at the value calculated by adding Δd1+Δd2+Δd3+Δd4+Δd5 to the deterioration rate in the initial state. While the above description has been made of the case where the states of the temperatures T1 to T5 occur, the present invention is not limited thereto, and the above processing can be performed in accordance with any number of temperature states.

The change amounts of deterioration rate are added in the order of the temperatures T1 to T5 in the above description. Even when the order of the addition of the change amounts of deterioration rate is changed, a generally equal deterioration rate is provided finally.

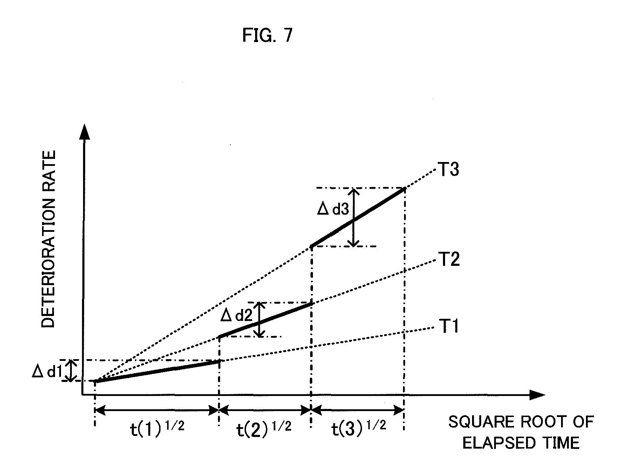

Fig. 6 shows the method of determining the deterioration rate of the assembled battery 11 when the time t2_total elapses based on the deterioration curves represented on the coordinate system of the deterioration rate and the elapsed time, the present invention is not limited thereto. When the deterioration rate is proportional to the nth root of the elapsed time, the coordinate system of the nth root of the elapsed time and deterioration rate can be used to represent deterioration data for each of temperatures in a straight line as shown in Fig. 7. In Fig. 7, the vertical axis represents the deterioration rate, and the horizontal axis represents the square root of the elapsed time.

In the coordinate system shown in Fig. 7, deterioration data at the temperature T1 can be used to provide a change amount Δd1 of deterioration rate associated with the square root of the period t (1). The period t(1) is the period occupied by the state of the temperature T1 as described above. The change amount Δd1 corresponds to the change amount Δd1 described in Fig. 6.

Similarly, deterioration data at the temperature T2 can be used to provide a change amount Δd2 of deterioration rate associated with the square root of the period t(2). The period t(2) is the period occupied by the state of the temperature T2. The change amount Δd2 corresponds to the change amount Δd2 described in Fig. 6. Deterioration data at the temperature T3 can be used to provide a change amount Δd3 of deterioration rate associated with the square root of the period t(3). The period t(3) is the period occupied by the state of the temperature T3. The change amount Δd3 corresponds to the change amount Δd3 described in Fig. 6.

The change amounts Δd1 to Δd3 of deterioration rate shown in Fig. 7 can be added to determine the future deterioration rate in the assembled battery 11 similarly to the case described in Fig. 6. Since the deterioration rate is proportional to the square root of the elapsed time in the coordinate system shown in Fig. 7, the results similar to those shown in Fig. 6 can be acquired only by adding the change amounts of deterioration rate provided at the respective temperatures.

The calculation (estimation) of the deterioration rate described with reference to Fig. 6 can be performed on the basis of the following expression (4).

$$\Delta d_{total} \;=\; \sqrt{\sum \left(v(T_k)^2 \;*\; F(T_k) \;*\; t2_{total}\right)} \qquad (4)$$

where Δd_total represents the change amount of deterioration rate when the period t2_total elapses. The change amount Δd_total can be added to the deterioration rate in the initial state to determine the deterioration rate of the assembled battery 11 when the period t2_total elapses. V(Tk) represents a deterioration speed at the temperature Tk and corresponds to the deterioration curve described in Fig. 6. F(Tk) represents the frequency of occurrence of the temperature Tk, and specifically, indicates the proportion of the temperature Tk in the period t2_total.

The above expression (4) can be represented as the following expression (5) when the above expression (3) is considered.

$$\Delta d_{total} \;=\; \sqrt{\sum \left(v(T_k)^2 \;* t2(T_k)\right)} \qquad (5)$$

According to the present embodiment, the change amount of deterioration rate when the period t2_total elapses can be estimated, and the deterioration rate of the assembled battery 11 when the period t2_total elapses can be estimated. Once the deterioration rate of the assembled battery 11 can be estimated, the timing of exchanging the assembled battery 11 can be determined. Specifically, it is possible to predict the period t2_total when the deterioration rate of the assembled battery 11 reaches a preset threshold value, and the predicted period t2_total can be notified to a user or the like with sound, display or the like.

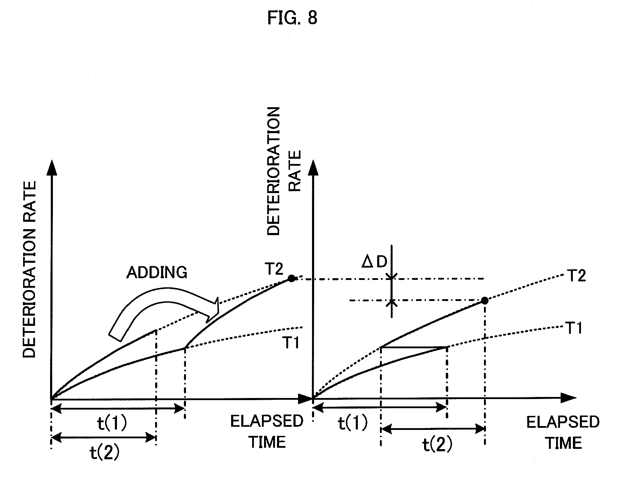

In the present embodiment, the accuracy of the estimation of the deterioration rate can be improved as compared with the case where deterioration curve specified on the coordinate system of the deterioration rate and the elapsed time is used to calculate the change amount of deterioration rate at each temperature and the calculated change amounts are simply added. In the following, specific description is made with reference to Fig. 8.

A graph on the right side in Fig. 8 shows the method of calculating the deterioration rate described in the present embodiment, whereas a graph on the left side in Fig. 8 shows a method of calculating the deterioration rate as a comparative example. In the calculation method shown on the left side in Fig. 8, change amounts of deterioration rate at temperatures T1 and T2 are calculated from the same point in time.

As shown in Fig. 8, a difference ΔD occurs in deterioration rate as a cumulative value between the calculation method on the left side and the calculation method on the right side. While the calculation method shown on the left side in Fig. 8 includes the calculation of the change amount of deterioration rate at each of the temperatures T1 and T2 by using the deterioration rate in the initial state as the reference, the method does not take the actual deterioration state in the assembled battery 11 into account. In the actual use of the assembled battery 11, deterioration occurs at a particular temperature and then deterioration occurs at another temperature. Thus, the deterioration processes at the two temperatures do not proceed from the same deterioration rate as the reference.

According to the present embodiment, since the deterioration rate used as the reference is changed in calculating the change amount of deterioration rate at each temperature, the deterioration rate can be estimated accurately in view of the use state of the assembled battery 11.

While the deterioration state of the assembled battery 11 is estimated in the present embodiment, the present invention is not limited thereto. Specifically, the deterioration state of the cells 10 constituting the assembled battery 11 can be estimated similarly to the present embodiment. When the plurality of cells 10 constituting the assembled battery 11 is divided into a plurality of blocks, the deterioration state of each of the blocks can be estimated similarly to the present embodiment. One block is formed of at least two cells 10.

While the present embodiment has been described in conjunction with the case where the deterioration rate is proportional to the square root of the elapsed time, the present invention is not limited thereto. The present invention is also applicable when the deterioration rate is proportional to the nth root of the elapsed time.

Specifically, the change amount of deterioration rate can be calculated on the basis of the following expression (6).

$$\Delta d_{total} = \sqrt[n]{\sum (v(T_k)^n * F(T_k) * t2_{total})} \qquad (6)$$

where v(Tk) represents the deterioration speed at the temperature Tk, and the deterioration speed is represented by the change in deterioration rate with respect to the elapsed time as described in Fig. 6. F(Tk) represents the frequency of occurrence of the state of the temperature Tk, t2_total represents the period when the deterioration of the assembled battery 11 is predicted, and n is a number larger than one.

The above expression (6) can also be represented as the following expression (7) when the above expression (3) is considered.

$$\Delta d_{total} = \sqrt[n]{\sum (v(T_k)^n * t2(T_k))} \qquad (7)$$

Once n can be determined, the change amount Δd_total of deterioration rate can be calculated with the above expression (6). To determine n, the relationship between the deterioration rate of the assembled battery 11 of interest and the elapsed time is calculated first. Next, the relationship between the deterioration rate and the elapsed time is plotted on the coordinate system in which the vertical axis represents the deterioration rate and the horizontal axis represents the nth root of the elapsed time. A plurality of coordinate systems are provided by changing n in a range larger than one. The determination of n can be performed by specifying one of the plurality of coordinate systems having the different values of n that allows the best linear approximation of the plotted deterioration rate.

While the change amount of deterioration rate is calculated with the deterioration curves at the respective temperatures in the present embodiment, the present invention is not limited thereto. The deterioration rate of the assembled battery 11 is changed not only with temperature but also with the SOC (State Of Charge) indicating the charge state, the voltage, and the current. When the SOC or the like is changed, characteristics similar to those shown in Fig. 6 (deterioration curves) can be obtained. As the SOC is higher, the deterioration rate is higher.

Thus, the above expression (6) can be represented as the following general expression (8).

$$\Delta d_{total} = \sqrt[n]{\sum (v(f)^n * F * t_{total})} \qquad (8)$$

where v(f) represents the deterioration speed under each deterioration condition such as the temperature or the SOC described above, and the deterioration speed can be represented as a change in deterioration rate with respect to the elapsed time. F represents the frequency of occurrence of the deterioration condition, and t_total represents the period when the deterioration state is predicted.

The above expression (8) can be represented as the following expression (9).

$$\Delta d_{total} = \sqrt[n]{\sum (v(f)^n * t(f))} \qquad (9)$$

where t(f) represents the period (predicted period) for which the deterioration condition occurs.

The deterioration speed v(f) in the above expressions (8) and (9) can be represented as a function of at least one of the SOC, the voltage, and the current, rather than a function of only the temperature. Since the SOC and the voltage generally have a correspondence, either of those values can be used. The deterioration speed v(f) can be represented by the following expression (10), for example.

$$v(f) = a * T_k + b * V + c * I + d \qquad (10)$$

where a variable V represents the voltage value of the assembled battery 11, and can be acquired with the voltage sensor 22 as described in Fig. 2. The voltage value V may be replaced with the SOC of the assembled battery 11. A variable I represents the value of the current passing through the assembled battery 11 and can be acquired with the current sensor 21 as described in Fig. 2. Each of a to d represents a constant.

The above expression (10) can also be represented as the following expression (11).

$$v(f) = a * \exp\left(\frac{-(b * V + C * I + d)}{T_k}\right) + e \qquad (11)$$

where e represents a constant.

The factor which influences the deterioration of the assembled battery 11 most is the temperature. Thus, the frequency of occurrence $F(T_k)$ of the temperature $T_k$ can be used as the frequency of occurrence F in the above expression (8), as shown in the above expression (6). The period $t2(T_k)$ occupied by the state of the temperature $T_k$ can be used as the period t(f) of occurrence of the deterioration condition in the above expression (9), as shown in the above expression (7).

The above deterioration speed v(f) can be corrected on the basis of the actual deterioration state (deterioration rate) of the assembled battery 11 (or the cell 10). Specifically, the actual deterioration state (deterioration rate) of the assembled battery 11 is detected, and the use environment of the assembled battery 11 is detected. The use environment of the assembled battery 11 is used for estimating the deterioration state of the assembled battery 11 with the estimation method described in the present embodiment.

The detected use environment of the assembled battery 11 and the estimation method described in the present embodiment are used to estimate the deterioration state of the assembled battery 11. The estimated deterioration state is compared with the detected deterioration state, and when they do not match generally, the deterioration speed v(f) can be corrected. Specifically, the deterioration speed v(f) can be corrected such that the estimated deterioration state matches the detected deterioration state. When the deterioration speed v(f) is corrected, the accuracy of the estimation of the deterioration state after the correction can be improved.

[DESCRIPTION OF THE REFERENCE NUMERALS]

| | |
|---|---|
| 10 | cell |
| 11 | assembled battery |
| 21 | current sensor |
| 22 | voltage sensor |
| 23 | temperature sensor |
| 30 | battery ECU |
| 31 | memory |
| 41a, 41b | system main relay |
| 42 | step-up circuit |
| 43 | inverter |
| 44 | motor generator |

**Claims**

1. A deterioration estimating apparatus estimating a deterioration state of an electric storage element when the electric storage element is used, a deterioration value indicating the deterioration state being in a proportional relationship with an nth root of an elapsed time (where n is a value larger than one), and the proportional relationship being changed in accordance with a deterioration condition, comprising:

   a computing device accumulating change amounts of the deterioration value in a plurality of the deterioration conditions and calculating a deterioration value of the electric storage element when a predetermined time period elapses,
   wherein the computing device predicts a period for which each of the deterioration conditions occurs before the elapse of the predetermined time period, and
   the computing device calculates a change amount of the deterioration value in each of the deterioration conditions based on a deterioration characteristic indicating a relationship between the deterioration value and the elapsed time and the period of occurrence of each of the deterioration conditions, and adds the calculated change amounts sequentially by using the deterioration value provided before each addition as a reference to calculate each change amount of the deterioration value to be added.

2. The deterioration estimating apparatus according to claim 1, wherein the computing device calculates the total sum of the change amounts of the deterioration value based on the following expression (Ex1):

$$\Delta d_{total} = \sqrt[n]{\sum \left( v(f)^n * t(f) \right)} \qquad (Ex1)$$

   where $\Delta d\_total$ represents the total sum of the change amounts of the deterioration value, $v(f)$ represents a deterioration speed provided for each of the deterioration conditions and indicating a change in the deterioration value with respect to the elapsed time, and $t(f)$ represents the predicted period of occurrence of each of the deterioration conditions.

3. The deterioration estimating apparatus according to claim 1 or 2, further comprising a memory storing the deterioration characteristic in each of the deterioration conditions.

4. The deterioration estimating apparatus according to any one of claims 1 to 3, further comprising a detection sensor configured to detect the deterioration condition; and
a timer measuring a time,
wherein the computing device uses the detection sensor and the timer to acquire a period of occurrence of each of the deterioration conditions before the elapse of a time period shorter than the predetermined time period, and based on the acquired period of occurrence, predicts the period of occurrence of each of the deterioration conditions before the elapse of the predetermined time period.

5. The deterioration estimating apparatus according to any one of claims 1 to 4, further comprising an acquiring sensor configured to acquire the deterioration value; and
a timer measuring a time,
wherein the computing device determines whether or not the deterioration value acquired with the acquiring sensor is proportional to an nth root of an elapsed time acquired with the timer, and when the deterioration value is proportional to the nth root of the elapsed time, the computing device calculates the deterioration value of the electric storage element when the predetermined time period elapses.

6. The deterioration estimating apparatus according to any one of claims 1 to 5, wherein the deterioration value is a ratio between an internal resistance of the electric storage element in an initial state and an internal resistance of the electric storage element in a deteriorated state.

7. The deterioration estimating apparatus according to any one of claims 1 to 6, wherein the deterioration condition includes at least one of a temperature in the electric storage element, a value indicating a charge state, and a current value.

8. The deterioration estimating apparatus according to any one of claims 1 to 7, wherein the n is equal to two.

9. A deterioration estimating method estimating a deterioration state of an electric storage element when the electric storage element is used, a deterioration value indicating the deterioration state being in a proportional relationship with an nth root of an elapsed time (where n is a value larger than one), and the proportional relationship being changed in accordance with a deterioration condition, comprising:

   a first step of predicting a period for which each of the deterioration conditions occurs before the elapse of a predetermined time period; and
   a second step of calculating a change amount of the deterioration value in each of the deterioration conditions based on a deterioration characteristic indicating a relationship between the deterioration value and the elapsed time and the period of occurrence of each of the deterioration conditions, and adding the calculated change amounts sequentially to calculate a deterioration value of the electric storage element when the predetermined time period elapses,
   wherein, at the second step, each change amount of the deterioration value to be added is calculated by using the deterioration value provided before each addition as a reference.

10. The deterioration estimating method according to claim 9, wherein the total sum of the change amounts of the deterioration value is calculated on the basis of the following expression (Ex2):

$$\Delta d_{total} = \sqrt[n]{\sum \left( v(f)^n * t(f) \right)} \qquad (Ex2)$$

where $\Delta d\_total$ represents the total sum of the change amounts of the deterioration value, $v(f)$ represents a deterioration speed provided for each of the deterioration conditions and indicating a change in the deterioration value with respect to the elapsed time, and $t(f)$ represents the period of occurrence of each of the deterioration conditions predicted at the first step.

EP 2 565 660 A1

FIG. 1

21 — Ⓐ

22 — Ⓥ

10 —

Ⓣ

23

LOAD

BATTERY
ECU — 30

MEMORY — 31

LOAD

12

FIG. 2

FIG. 3

```
                    ┌──────────────┐
                    │    START     │
                    └──────┬───────┘
                           │
                           ▼
S101 ───  ┌────────────────────────────────┐
          │   START COUNTING OF TIMER       │
          └────────────────┬───────────────┘
                           │
                           ▼
S102 ───  ┌────────────────────────────────┐
          │   DETECT TEMPERATURE OF         │
          │   ASSEMBLED BATTERY             │
          └────────────────┬───────────────┘
                           │
                           ▼
S103 ───      ◇ TEMPERATURE CHANGED ? ◇ ──── No
                           │
                          Yes
                           ▼
S104 ───  ┌────────────────────────────────┐
          │   STOP COUNTING OF TIMER        │
          └────────────────┬───────────────┘
                           │
                           ▼
                    ┌──────────────┐
                    │    RETURN     │
                    └──────────────┘
```

FIG. 4

FIG. 5

```
                    ┌──────────────┐
                    │    START     │
                    └──────┬───────┘
                           │
                           ▼
S201 ～      ┌──────────────────────────────┐
            │   START COUNTING OF TIMER     │
            └──────────────┬───────────────┘
                           │
                           ▼
S202 ～      ┌──────────────────────────────┐
            │  DETECT CURRENT AND VOLTAGE   │
            └──────────────┬───────────────┘
                           │
                           ▼
S203 ～      ┌──────────────────────────────┐
            │  CALCULATE BATTERY RESISTANCE │
            │  CALCULATE DETERIORATION RATE │
            └──────────────┬───────────────┘
                           │
                           ▼
S204 ～         ╱─────────────────────────╲         No
            ◄──  DETERIORATION RATE        ──►──────┐
                 PROPORTIONAL TO SQUARE ROOT OF     │
                 ╲   ELAPSED TIME ?        ╱        │
                           │                        │
                          Yes                       │
                           ▼                        │
S205 ～      ┌──────────────────────────────┐       │
            │   CALCULATE FUTURE            │       │
            │   DETERIORATION RATE BASED ON │       │
            │   DETERIORATION CHARACTERISTIC│       │
            │   AT EACH TEMPERATURE AND     │       │
            │   FREQUENCY OF OCCURRENCE OF  │       │
            │   EACH TEMPERATURE            │       │
            └──────────────┬───────────────┘       │
                           │◄─────────────────────┘
                           ▼
                    ┌──────────────┐
                    │     END      │
                    └──────────────┘
```

FIG. 6

FIG. 7

FIG. 8

## INTERNATIONAL SEARCH REPORT

International application No.

PCT/JP2010/002995

| A. CLASSIFICATION OF SUBJECT MATTER |
|---|
| *G01R31/36*(2006.01)i |

According to International Patent Classification (IPC) or to both national classification and IPC

| B. FIELDS SEARCHED |
|---|

Minimum documentation searched (classification system followed by classification symbols)
G01R31/36

Documentation searched other than minimum documentation to the extent that such documents are included in the fields searched

| Jitsuyo Shinan Koho | 1922–1996 | Jitsuyo Shinan Toroku Koho | 1996–2010 |
| Kokai Jitsuyo Shinan Koho | 1971–2010 | Toroku Jitsuyo Shinan Koho | 1994–2010 |

Electronic data base consulted during the international search (name of data base and, where practicable, search terms used)

| C. DOCUMENTS CONSIDERED TO BE RELEVANT |

| Category* | Citation of document, with indication, where appropriate, of the relevant passages | Relevant to claim No. |
|---|---|---|
| Y<br>A | JP 9-293539 A (Shin-Kobe Electric Machinery Co., Ltd.),<br>11 November 1997 (11.11.1997),<br>entire text; all drawings<br>(Family: none) | 1,3,4,6-9<br>2,5,10 |
| Y<br>A | JP 2007-57433 A (Fuji Heavy Industries Ltd.),<br>08 March 2007 (08.03.2007),<br>entire text; all drawings<br>(Family: none) | 1,3,4,6-9<br>2,5,10 |

☐ Further documents are listed in the continuation of Box C.     ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 26 July, 2010 (26.07.10) | 03 August, 2010 (03.08.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003161768 A
- JP 2007057433 A

- JP 2000228227 A